# EUROPÄISCHE PATENTSCHRIFT

(11) **EP 0 902 532 B1**
(45) Veröffentlichungstag und Bekanntmachung des Hinweises auf die Patenterteilung: **31.03.2004**
(21) Anmeldenummer: 98115904.9
(22) Anmeldetag: 24.08.1998
(51) Int. Cl.: H03D 1/22, H03D 7/16, H03C 1/00

(54) **Oszillatorschaltungsanordnung**
Oscillator circuit arrangement
Agencement de circuit oscillateur

(30) Priorität: 11.09.1997 DE 19740001
(43) Veröffentlichungstag der Anmeldung: 17.03.1999
(73) Patentinhaber: Infineon Technologies AG, 81669 München (DE)
(72) Erfinder: Fenk, Josef, 85386 Eching (DE)
(74) Vertreter: Epping, Hermann, Fischer

(56) Entgegenhaltungen:
- EP-A- 0 643 494
- EP-A- 0 739 090
- WO-A-92/01337
- US-A- 5 283 532

## Beschreibung

Die Erfindung betrifft eine Oszillatorschaltungsanordnung, die sowohl für einen Modulator, einen Demodulator, einen Abwärtsmischer oder beispielsweise auch ein Ausgangsverstärker.anwendbar ist.

Aus dem Stand der Technik EP 0 643 494 A1 ist ein homodyner Funkempfänger bekannt. Dieser ist in Figur 1 gezeigt. Ein von einer Antenne 12 empfangenes Signal wird mittels eines Bandpasses 15 gefiltert. Das Bandpaßfilter 15 dient dazu, das richtige Kommunikationsband auszuwählen. Dem Bandpaßfilter 15 ist ein Verstärker 16 nachgeschaltet. Eine hohe Verstärkung führt zu einer hohen Empfindlichkeit und eine niedrige Verstärkung ist wünschenswert, wenn eine gute Dynamik und eine saubere Intermodulationscharakteristik erreicht werden soll. Das Ausgangssignal des Verstärkers 16 wird in zwei Signalanteile aufgespalten und je einem Mischer 11 und 11' zugeführt. Ein lokaler Oszillator LO, der mit einer Frequenz fLo schwingt, ist mit einem Multiplizierer 13 verbunden. Der Multiplizierer 13 multipliziert die Frequenz fLo mit einem Multiplikator M (bevorzugterweise M = 3). Anschließend wird die Frequenz M x fLo durch einen geradzahligen Faktor N geteilt (bevorzugterweise N = 2). Das dadurch erzeugte Signal mit der Frequenz M : N x fLo wird einem Phasenschieber 19 zugeführt, der daraus ein Inphasesignal (Phasenverschiebung = 0°) und ein Quadratursignal (Phasenschiebung = 90°) erzeugt, welche zusätzlich den Mischern 11 und 11' zugeführt werden. Die Mischer 11 und 11' wandeln das hochfrequente Eingangssignal in ein Inphase-Basisbandsignal I' bzw. ein Quadratur-Basisbandsignal Q' um. Die Mischer 11 und 11' können aktive oder passive Schaltungselemente sein. Den Mischern 11 und 11' sind Tiefpaßfilter 17 und 17' und Verstärker 18 und 18' nachgeschaltet, um den gewünschten Signalanteil herauszufiltern und zu verstärken. Ein Nachteil an dieser Ausführungsform ist, daß der lokale Oszillator LO nicht in einen Chip integriert ist.

Eine Aufgabe der Erfindung ist es, eine Schaltungsanordnung anzugeben, bei der der Nachteil des Standes der Technik vermieden wird.

Die Aufgabe wird durch eine Schaltungsanordnung gemäß Patentanspruch 1 gelöst.

Die erfindungsgemäße Schaltungsanordnung weist einen Hauptoszillator und einen dem Hauptoszillator nachgeschalteten untergeordneten Oszillator auf. Der Hauptoszillator erzeugt ein Signal mit einer x-ten Oberschwingung, wobei die Oberschwingung zum Anregen des untergeordneten Oszillators dient. Weiterhin ist ein Teiler vorgesehen, der mit dem untergeordneten Oszillator verbunden ist und die Frequenz des Ausgangssignals des untergeordneten Oszillators durch einen ganzzahligen Teilerwert erteilt, wobei der Teilerwert vom Wert x abweicht.

Vorteilhafte Weiterbildungen ergeben sich aus den abhängigen Ansprüchen.

So ist ein Rückkopplungszweig vorgesehen, der das vom untergeordneten Oszillator erzeugte Ausgangssignal mit einem Referenzsignal vergleicht, ein Steuersignal erzeugt und dem untergeordneten Oszillator zuführt.

Eine Ausführungsform des Rückkopplungszweigs sieht vor, daß ein Frequenzteiler vorgesehen ist, der die Frequenz des Ausgangssignals teilt und einem Frequenzvergleicher zuführt, der die geteilte Frequenz mit einer Referenzfrequenz vergleicht und einen Sollwert ausgibt. Zusätzlich ist ein Mittel zur Umsetzung des Sollwerts in ein Steuersignal vorgesehen, daß dem Frequenzvergleicher nachgeschaltet ist und ausgangsseitig mit dem untergeordneten Oszillator verbunden ist.

Der Rückkopplungszweig ist vorteilhafterweise so ausgeführt, daß der Rückkopplungszweig geöffnet und der Hauptoszillator mit dem untergeordneten Oszillator verbunden wird, sobald sich die Frequenz des vom untergeordneten Oszillator erzeugten Ausgangssignals im Fangbereich des Hauptoszillators befindet.

Weiterhin kann ein zweiter Rückkopplungszweig vorgesehen sein, der das vom Hauptoszillator stammende Signal mit einem weiteren Referenzsignal vergleicht, daraus ein Hauptoszillator-Steuersignal bestimmt und dem Hauptoszillator zuführt.

Der untergeordnete Oszillator kann beispielsweise einem Modulator, einem Demodulator, einem Abwärtsmischer oder einem Ausgangsverstärker vorgeschaltet sein.

Die Schaltungselemente der erfindungsgemäßen Schaltungsanordnung sind vorteilhafterweise in einem Chip integriert.

Die Erfindung wird anhand von Figuren weiter erläutert.
- Figur 1: zeigt ein Blockschaltbild eines homodynen Empfängers gemäß den Stand der Technik.
- Figur 2: zeigt eine erste Anwendung der erfindungsgemäßen Schaltungsanordnung in einem Offset-Sender.
- Figur 3: zeigt eine zweite Anwendungsform der erfindungsgemäßen Schaltungsanordnung in Verbindung mit einem Mischer.
- Figur 4: zeigt eine dritte Anwendungsform der erfindungsgemäßen Schaltungsanordnung als I/Q Direkt-Modulator.
- Figur 5: zeigt eine vierte Anwendungsform der erfindungsgemäßen Schaltungsanordnung als I/Q Direkt-Demodulator.
- Figur 6: zeigt den Teil der erfindungsgemäßen Schaltungsanordnung der zur Erzeugung des Oszillatorausgangssignals dient.

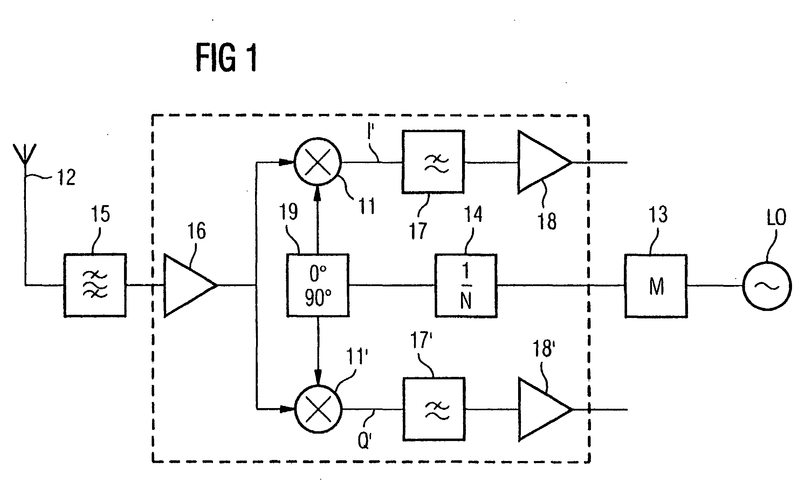

Auf den in Figur 1 gezeigten Stand der Technik wurde bereits weiter oben eingegangen.

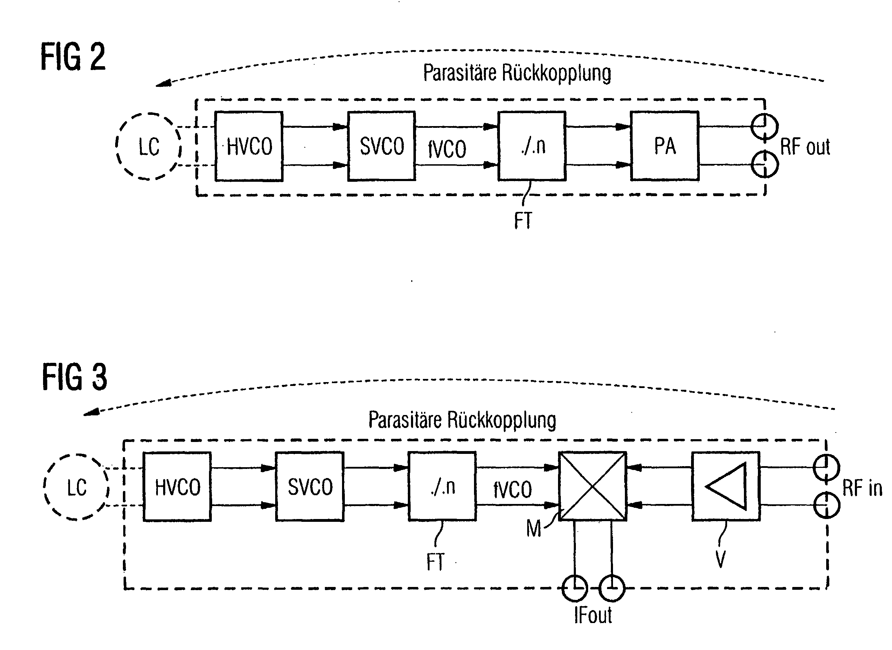

Der in Figur 2 dargestellte Offset-Sender weist einen LC-Schwingkreis auf, der zur Einstellung der Schwingfrequenz eines spannungsgesteuerten Oszillators HVCO dient. Der spannungsgesteuerte Oszillator HVCO, im folgenden auch als Hauptoszillator bezeichnet, erzeugt neben der Grundfrequenz auch Oberschwingungen, wobei eine der Oberschwingungen, beispielsweise die x-te Oberschwingung genutzt wird, um einen untergeordneten Oszillator SVCO zu steuern. Wegen der symmetrischen Anordnung erzeugt der Hauptoszillator HVCO bevorzugt ungeradzahlige Oberschwingungen. Der untergeordnete Oszillator SVCO erzeugt ein Ausgangssignal, dessen Grundfrequenz der x-ten Oberschwingung des Hauptoszillators HVCO entspricht. Das vom untergeordneten Oszillator SVCO erzeugte Signal mit der Frequenz fVCO wird einem Frequenzteiler FT zugeführt, der die Frequenz fVCO durch einen Teilerwert n teilt. Der Teilerwert n ist dabei so zu wählen, daß falls der untergeordnete Oszillator SVCO auf einer geradzahligen harmonischen des Hauptoszillators HVCO schwingt ungeradzahlig ist und der Teilerwert n geradzahlig ist, wenn der untergeordnete Oszillator SVCO auf einer Frequenz fVCO schwingt, die eine ungeradzahlige Harmonische der Frequenz des Hauptoszillators HVCO ist. Das so erzeugte Signal mit der Frequenz fVCO : n am Ausgang des Frequenzteilers FT wird einem Ausgangsverstärker PA zugeführt. An dessen Ausgang ist ein Sendesignal RFout abgreifbar.

Durch die beschriebene Schaltungsanordnung wird vermieden, daß eine parasitäre Rückkopplung des Sendesignals RFout die Grundfrequenz des Hauptoszillators HVCO direkt stören kann.

In Figur 2 sind die Schaltungselemente Hauptoszillator HVCO, untergeordneter Oszillator SVCO, Frequenzteiler FT und Ausgangsverstärker PA auf einem Chip integriert. Das gepunktete Rechteck soll dies andeuten. Selbstverständlich besteht auch die Möglichkeit das LC-Netzwerk in den Baustein zu integrieren.

Das vom Hauptoszillator HVCO erzeugte Oszillatorsignal ist ein symmetrisches Signal.

Der Frequenzteiler FT kann beispielsweise in Form einer asynchronen Teilerkette (Johnson Counter) mit beispielsweise einem Teilerwert n = 2, 4 oder höher realisiert sein.

Das modulierte Ausgangssignal RFout kann trotz der parasitären Rückkopplung keinen störenden Einfluß auf den Hauptoszillator HVCO ausüben, da die Resonanzschwingfrequenz des Hauptoszillators HVCO und dessen Selektionseigenschaften den Grad der Rückwirkung dämpfen. Da das Ausgangssignal des Hauptoszillators HVCO wesentlich größer ist als das parasitär rückgekoppelte Ausgangssignal RFout folgt der untergeordnete Oszillator SVCO dem Hauptoszillator HVCO.

Durch einen Einsatz einer symmetrischen aktiven Schaltung beim Hauptoszillator HVCO werden die geradzahligen Harmonischen sehr gut unterdrückt und die ungeradzahligen Harmonischen folgen weitgehend dem Verlauf einer Rechteckschwingung, d. h. die dritte Harmonische hat einen Abstand von ca. 10 dB zur ersten Harmonischen. Diese Oberwelle wird genutzt, um den freischwingenden untergeordneten Oszillator SVCO, der auf die Arbeitsfrequenz annähernd abgestimmt ist, auf die dritte Harmonische abzustimmen. Im untergeordneten Oszillator SVCO wird die Grundwelle des Hauptoszillators HVCO ausreichend gut unterdrückt, so daß die Teilerkette mit einem um 20 dB unterdrückten Grundwellensignal angesteuert wird. Dies gilt grundsätzlich für alle gezeigten Schaltungen.

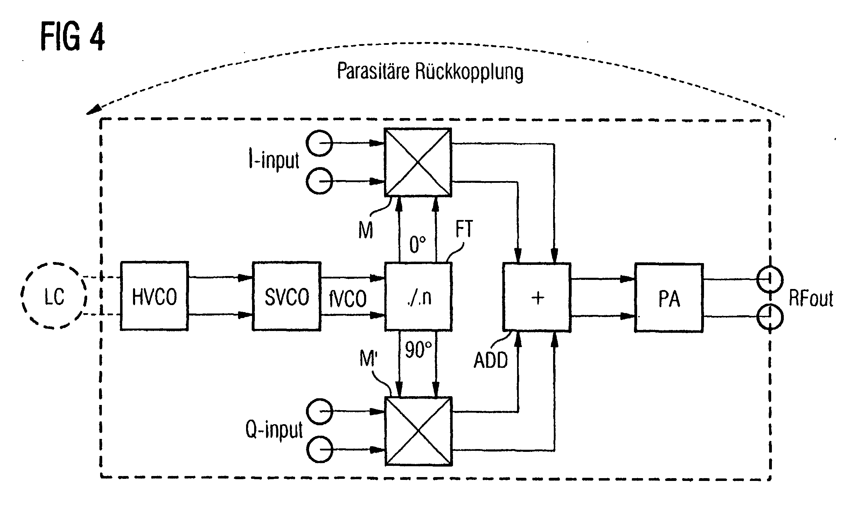

Die in Figur 3 gezeigte Schaltungsanordnung dient als Mischer bei sehr niedriger ZF-Frequenz. Ein mittels eines Verstärker V verstärktes Funksignal RFin wird auf ein Mischer M geführt, der zusätzlich das Signal mit der Frequenz fVCO erhält und diese zu einem Ausgangssignal IFout mischt.

In der Funktionsweise besteht zu den in der Figur 2 gezeigten Schaltungselementen LC-Schwingkreis, Hauptoszillator HVCO untergeordneter Oszillator SVCO und Frequenzteiler FT mit Teilerwert n kein Unterschied.

Die Abwärtsmischung bei der in Figur 3 gezeigten Schaltungsanordnung kann bis auf die gleiche Frequenz wie das Eingangssignal erfolgen. Dies ist z. B. vorteilhaft, wenn man ein IF-Sampling, das dem Mischer nachgeordnet ist, einsetzen möchte.

Die in Figur 4 gezeigte Schaltungsanordnung dient zur I/Q-Direktmodulation. Die Schaltungselemente LC Schwingkreis, Hauptoszillator HVCO, untergeordneter Oszillator SVCO und Frequenzteiler FT entsprechen den bereits oben beschriebenen Elementen. Zusätzlich weist der Frequenzteiler FT in Figur 4 einen Phasenschieber auf, der das durch n geteilte Signal mit der Frequenz fVCO in einen I-Anteil (Phasenverschiebung = 0°) und einen Q-Anteil (Phasenverschiebung = 90°) aufteilt. Der I-Anteil wird mittels des Mischers M mit einem Inphase-Eingangssignal I-Input gemischt und auf einen Addierer ADD geführt. Der Q-Anteil wird mittels des Mischers M' mit einem Quadratur-Eingangssignal Q-Input gemischt und ebenfalls dem Addierer ADD zugeführt. Dem Addierer ADD ist ein Ausgangsverstärker PA nachgeschaltet, an dessen Ausgangsklemmen das Ausgangssignal RFout abgreifbar ist.

Bei der in Figur 4 gezeigten Vektormodulation führt eine parasitäre Rückkopplung ebenso wie bei den anderen Schaltungsanordnungen nicht zu einem störenden Einfluß auf den Hauptoszillator HVCO.

Wird als Frequenzteiler FT ein asynchroner Teiler verwendet, so hat man die erforderlichen 0° und 90° für den I- bzw. Q-Anteil einfach zur Verfügung.

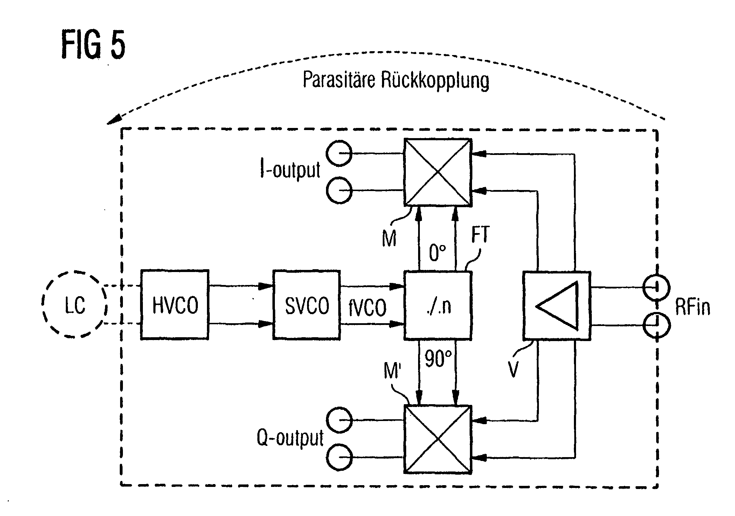

Die Schaltungsanordnung in Figur 5 unterscheidet sich von der in Figur 4 gezeigten dadurch, daß anstelle des Addierers ADD und des Ausgangsverstärkers PA ein Eingangsverstärker V vorgesehen ist, an dessen Eingängen das Eingangssignal RFin anliegt. Die Schaltungsanordnung dient zur I/Q-Direktmodulation nach dem Homodyn-Konzept. Das vom Eingangsverstärker V erzeugte Signal wird den beiden Mischer M und M' zugeführt, mit dem I- bzw. Q-Anteil, welche vom Frequenzteiler FT stammen gemischt und sind an den Ausgängen der beiden Mischer M bzw. M' als Inphaseausgangssignal I-Output bzw. Quadraturausgangssignal Q-Output abgreifbar. Auch hier führt eine parasitäre Rückkopplung nicht zu Störungen beim Hauptoszillator HVCO. Ebenso wie in Figur 4 stehen durch die Verwendung eines asynchronen Teilers als Frequenzteiler FT die I- und Q-Anteile zur Verfügung.

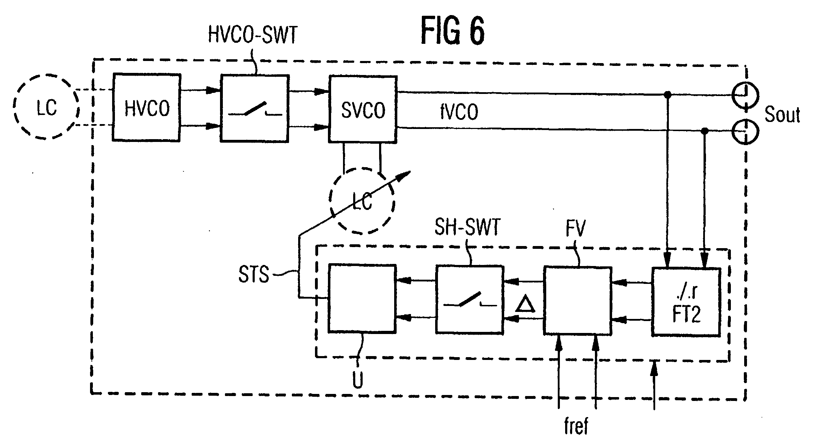

Bei dem in der Figur 6 gezeigten Ausführungsbeispiel ist ein Rückkopplungszweig vorgesehen, der das Ausgangssignal Sout des untergeordneten Oszillators SVCO abgreift, einem Frequenzteiler FT2 zuführt, um dies durch einen Teilerwert r zu teilen, und einem Frequenzvergleicher FV zuzuführen. Der Frequenzvergleicher FV vergleicht die durch den Teilerwert r geteilte Frequenz fVCO : r mit einer Referenzfrequenz fref und gibt einen Sollwert Δ an einen Sample and Hold Schalter SH-SWT aus. Der Sollwert Δ wird falls der Sample and Hold Schalter SH-SWT geschlossen ist, durch ein Mittel zur Umsetzung U des Sollwerts Δ in ein Steuersignal STS umgesetzt. Der Umsetzer U stellt die Frequenz solange nach, bis der Frequenzfehler Δ minimal ist. Das Steuersignal STS wirkt auf den LC-Schwingkreis des untergeordneten Oszillators SVCO. Weiterhin ist ein RF-Signalpfad-Schalter HVCO-SWT vorgesehen, der zwischen den Hauptoszillator HVCO und den untergeordneten Oszillator SVCO geschaltet ist. Der RF-Signalpfad-Schalter HVCO-SWT reicht wahlweise das vom Hauptoszillator HVCO stammende Signal an den untergeordneten Oszillator SVCO weiter.

Der beschriebene Regelkreis arbeitet solange, bis die Frequenz fVCO des untergeordneten Oszillators SVCO grob eingestellt ist. Anschließend wird der Rückkopplungszweig geöffnet und der Hauptoszillator HVCO mit dem untergeordneten Oszillator SVCO verbunden, um die Frequenz fVCO des untergeordneten Oszillators SVCO exakt einzustellen.

Der Frequenzvergleicher FV wird mit einem externen Referenzsignal mit der Referenzfrequenz fref, das von einem externen Quarz stammt, gespeist. Der Umsetzer U kann beispielsweise ein Pulslängen zu Stromwandler oder ein Pulslängenzuspannungswandler sein.

Es handelt sich hier um einen Sample- und Hold-Vorgang bei der Frequenzeinstellung des untergeordneten Oszillators SVCO.

Alternativ könnte die Frequenz auch über eine Sample- und Hold-PLL (Phase Looked Loop) eingestellt werden. Da im ersten Regelkreis geringere Anforderungen an die Genauigkeit gestellt werden, kann die Frequenz fVCO durch einen Zähler ermittelt werden.

Neben dem in Figur 6 gezeigten Regelkreis zur Einstellung der Frequenz fVCO des untergeordneten Oszillators SVCO kann ein weiterer Regelkreis zur Einstellung der Arbeitsfrequenz des Hauptoszillators HVCO vorgesehen sein. Dieser ist in Figur 6 nicht gezeigt.

Den Figuren 2 bis 6 ist gemeinsam, daß das gepunktet gezeichnete Rechteck die auf einem Chip integrierten Schaltungselemente kennzeichnet. Der außerhalb des gepunkteten Rechtecks gezeichnete LC-Schwingkreis kann jedoch ohne weiteres auch in den Chip integriert werden.

Den Figuren 2 bis 5 ist gemeinsam, daß der Hauptposzillator HVCO und der untergeordnete Oszillator SVCO grundsätzlich entsprechend der Anordnung gemäß Figur 6 beschaltet sind.

Alternativ könnte die Einrichtung zur Frequenznachführung, die den Frequenzteiler FT2, den Frequenzvergleicher FV, den Umsetzer U und am Ausgang des Umsetzers U das Steuersignal STS aufweist, die in Figur 6 den LC-Schwingkreis des untergeordneten Oszillator SVCO ansteuert, durch ein extern zugeführtes Steuersignal STS beaufschlagt werden.

Wenn der RF-Signalpfad-Schalter HVCO-SWT offen ist, ist gleichzeitig der Sample and Hold Schalter SH-SWT geschlossen. Dies entspricht dem sample mode. Im hold mode ist der RF-Signalpfad-Schalter HVCO-SWT geschlossen und der Sample and Hold Schalter SH-SWT offen.

## Patentansprüche

1. Schaltungsanordnung,
bei der ein Hauptoszillator (HVCO) und ein dem Hauptoszillator (HVCO) nachgeschalteter untergeordneter Oszillator (SVCO) vorgesehen sind,
bei der der Hauptoszillator (HVCO) ein Signal mit einer x-ten Oberschwingung erzeugt, wobei die Oberschwingung zum Anregen des untergeordneten Oszillators (SVCO) dient,
bei der ein Teiler (FT) vorgesehen ist, der mit dem untergeordneten Oszillator (SVCO) verbunden ist und die Frequenz (fVCO) des Ausgangssignals (Sout) des untergeordneten Oszillators (SVCO) durch einen ganzzahligen Teilerwert (n) teilt, wobei der Teilerwert (n) vom Wert x abweicht.

2. Schaltungsanordnung nach Anspruch 1,
bei der ein erster Rückkopplungszweig vorgesehen ist, der das vom untergeordneten Oszillator (SVCO) erzeugte Ausgangssignal (Sout) mit einem Referenzsignal (fref) vergleicht, ein Steuersignal (STS) erzeugt und dem untergeordneten Oszillator (SVCO) zuführt.

3. Schaltungsanordnung nach Anspruch 2,
bei der der erste Rückkopplungszweig einen Frequenzteiler (FT2) aufweist, der die Frequenz (fVCO) des Ausgangssignals (Sout) teilt,
bei der ein Frequenzvergleicher (FV) vorgesehen ist, der dem Frequenzteiler (FT2) nachgeschaltet ist, die geteilte Frequenz mit einer Referenzfrequenz (fref) vergleicht und einen Sollwert (Δ) ausgibt,
bei der ein Mittel zur Umsetzung des Sollwerts (Δ) in ein Steuersignal (StS) vorgesehen ist, das dem Frequenzvergleicher (FV) nachgeschaltet ist, und ausgangsseitig mit dem untergeordneten Oszillator (SVCO) verbunden ist.

4. Schaltungsanordnung nach Anspruch 3,
bei der der erste Rückkopplungszweig geöffnet und der Hauptoszillator (HVCO) mit dem untergeordneten Oszillator (SVCO) verbunden wird, sobald sich die Frequenz (fVCO) des vom untergeordneten Oszillator (SVCO) erzeugten Ausgangssignals (Sout) im Fangbereich des Hauptoszillators (HVCO) befindet.

5. Schaltungsanordnung nach Anspruch 3 oder 4,
bei der ein zweiter Rückkopplungsweig vorgesehen ist, der das vom Hauptoszillator (HVCO) stammende Signal mit einem weiteren Referensignal vergleicht, daraus ein Hauptoszillator-Steuersignal bestimmt und dem Hauptoszillator (HVCO) zuführt.

6. Schaltungsanordnung nach einem der Ansprüche 1 bis 5,
bei dem dem untergeordneten Oszillator (SVCO) ein Modulator nachgeschaltet ist.

7. Schaltungsanordnung nach einem der Ansprüche 1 bis 5,
bei dem dem untergeordneten Oszillator (SVCO) ein Demodulator nachgeschaltet ist.

8. Schaltungsanordnung nach einem der Ansprüche 1 bis 5,
bei dem dem untergeordneten Oszillator (SVCO) ein Abwärtrsmischer nachgeschaltet ist.

9. Schaltungsanordnung nach einem der Ansprüche 1 bis 5, bei dem dem untergeordneten Oszillator (SVCO) ein Ausgangsverstärker (PA) nachgeschaltet ist.

## Claims

1. Circuit arrangement,
in which a main oscillator (HVCO) and a subordinate oscillator (SVCO) connected downstream of the main oscillator (HVCO) are provided,
in which the main oscillator (HVCO) generates a signal having an x-th harmonic, the harmonic serving to excite the subordinate oscillator (SVCO),
in which a divider (FT) is provided which is connected to the subordinate oscillator (SVCO) and divides the frequency (fVCO) of the output signal (Sout) of the subordinate oscillator (SVCO) by an integer divider value (n), where the divider value (n) differs from the value x.

2. The circuit arrangement as claimed in Claim 1,
in which a first feedback path is provided which compares the output signal (Sout) generated by the subordinate oscillator (SVCO) with a reference signal (fref), generates a control signal (STS) and feeds it to the subordinate oscillator (SVCO).

3. The circuit arrangement as claimed in Claim 2,
in which the first feedback path has a frequency divider (FT2), which divides the frequency (fVCO) of the output signal (Sout),
in which a frequency comparator (FV) is provided which is connected downstream of the frequency divider (FT2), compares the divided frequency with a reference frequency (fref) and outputs a desired value (Δ),
in which a means for converting the desired value (Δ) into a control signal (StS) is provided, which means is connected downstream of the frequency comparator (FV) and, on the output side, is connected to the subordinate oscillator (SVCO).

4. The circuit arrangement as claimed in Claim 3,
in which the first feedback path is opened and the main oscillator (HVCO) is connected to the subordinate oscillator (SVCO) as soon as the frequency (fVCO) of the output signal (Sout) generated by the subordinate oscillator (SVCO) is in the capture range of the main oscillator (HVCO).

5. The circuit arrangement as claimed in Claim 3 or 4,
in which a second feedback path is provided which compares the signal originating from the main oscillator (HVCO) with a further reference signal and, from the comparison, determines a main oscillator control signal and feeds it to the main oscillator (HVCO).

6. The circuit arrangement as claimed in one of Claims 1 to 5,
in which a modulator is connected downstream of the subordinate oscillator (SVCO).

7. The circuit arrangement as claimed in one of Claims 1 to 5,
in which a demodulator is connected downstream of the subordinate oscillator (SVCO).

8. The circuit arrangement as claimed in one of Claims 1 to 5,
in which a down-converter is connected downstream of the subordinate oscillator (SVCO).

9. The circuit arrangement as claimed in one of Claims 1 to 5,
in which an output amplifier (PA) is connected downstream of the subordinate oscillator (SVCO).

## Revendications

1. Circuit oscillateur,
dans lequel il est prévu un oscillateur (HVCO) principal et un oscillateur (SVCO) subordonné monté en aval de l'oscillateur (HVCO) principal,
dans lequel l'oscillateur (HVCO) principal produit un signal ayant un x-ième harmonique, l'harmonique servant à exciter l'oscillateur (SVCO) subordonné,
dans lequel il est prévu un diviseur (FT) qui est relié à l'oscillateur (SVCO) subordonné et qui divise la fréquence (fVCO) du signal (Sout) de sortie de l'oscillateur (SVCO) subordonné par une valeur (n) de division en nombre entier, la valeur (n) de division différant de la valeur x.

2. Circuit suivant la revendication 1,
dans lequel il est prévu une première branche de réaction, qui compare le signal (Sout) de sortie produit par l'oscillateur (SVCO) subordonné à un signal (fref) de référence, qui produit un signal (STS) de commande et qui l'envoie à l'oscillateur (SVCO) subordonné.

3. Circuit suivant la revendication 2,
dans lequel la première branche de réaction a un diviseur (FT2) de fréquence qui divise la fréquence (fVCO) du signal (Sout) de sortie,
dans lequel il est prévu un comparateur (FV) de fréquence, qui est monté en aval du diviseur (FT2) de fréquence, qui compare la fréquence divisée à une fréquence (fref) de référence et qui émet une valeur (Δ) de consigne,
dans lequel il est prévu un moyen de transformation de la valeur (Δ) de consigne en un signal (StS) de commande, qui est monté en aval du comparateur (FV) de fréquence et qui est relié du côté sortie à l'oscillateur (SVCO) subordonné.

4. Circuit suivant la revendication 3,
dans lequel la première branche de réaction est ouverte et l'oscillateur (HVCO) principal est relié à l'oscillateur (SVCO) subordonné dès que la fréquence (fVCO) du signal (Sout) de sortie produit par l'oscillateur (SVCO) subordonné se trouve dans la plage de capture de l'oscillateur (HVCO) principal.

5. Circuit suivant la revendication 3 ou 4,
dans lequel il est prévu une deuxième branche de réaction qui compare le signal issu de l'oscillateur (HVCO) principal à un autre signal de référence, en détermine un signal de commande de l'oscillateur principal et l'envoie à l'oscillateur (HVCO) principal.

6. Circuit suivant l'une des revendications 1 à 5,
dans lequel un modulateur est monté en aval de l'oscillateur (SVCO) subordonné.

7. Circuit suivant l'une des revendications 1 à 5,
dans lequel un démodulateur est monté en aval de l'oscillateur (SVCO) subordonné.

8. Circuit suivant l'une des revendications 1 à 5,
dans lequel un mélangeur-abaisseur est monté en aval de l'oscillateur (SVCO) subordonné.

9. Circuit suivant l'une des revendications 1 à 5,
dans lequel un amplificateur (PA) de sortie est monté en aval de l'oscillateur (SVCO) subordonné.
